# EUROPEAN PATENT APPLICATION

(11) **EP 4 572 558 A1**
(43) Date of publication of application: **18.06.2025**
(21) Application number: 24192877.9
(22) Date of filing: 05.08.2024
(51) Int. Cl.: H10D 30/01, H01L 21/285, H10D 30/69, H10D 62/00, H10D 62/822, H10D 84/01

(54) **PMOS TRANSISTOR AND METHOD OF PREPARING PMOS TRANSISTOR, CMOS CIRCUIT AND METHOD OF PREPARING CMOS CIRCUIT**

(30) Priority: 12.12.2023 CN 202311704787
(71) Applicant: SwaySure Technology Co., Ltd., Shenzhen (CN)
(72) Inventor: HSIEH, Ming-Hung, Shenzhen (CN)
(74) Representative: Studio Torta S.p.A.

(57) **Abstract**

The present application provides a method of preparing a PMOS transistor, including: providing a substrate (10), and forming source-drain trenches (11) on the substrate (10); growing SiGe material within the source-drain trenches (11) to form a SiGe layer (30), and growing a Si thin film layer (40) on a surface of the SiGe layer (30) to form a stacked layer structure of the SiGe layer (30) and the Si thin film layer (40); and growing a first Co thin film layer (50) on the stacked layer structure, and performing an annealing treatment, to make Co in the first Co thin film layer (50) react with Si in the Si thin film layer (40) to form a first CoSi₂ thin film layer (22); an overall structure formed within the source-drain trenches (11) is a source-drain, and the first CoSi₂ thin film layer (22) is an upper structure of the source-drain.

## Description

### TECHNICAL FIELD

The present application belongs to the field of semiconductor technology, and particularly relates to a positive channel Metal Oxide Semiconductor (PMOS) transistor and a method of preparing a PMOS transistor, a Complementary Metal Oxide Semiconductor (CMOS) circuit and a method of preparing a CMOS circuit.

### BACKGROUND

There are a total of three phases for silicon cobalt alloys, including Si₂Co, SiCo, and CoSi₂ ,where CoSi₂ is a low resistance phase and the Co₂Si, and CoSi have a high resistance, which leads to an increase of the resistance at the source-drain of the PMOS. In the thin film deposition process, the Co film is deposited first, and after a Rapid Thermal Processing (RTP) (250° C~410° C), the Co film diffuses into Si as a diffusion source, to form Co₂Si first, and as the temperature of RTP (410° C~510° C) increases, the Co film further diffuses and forms CoSi gradually. When the temperature of RTP (>750° C) further increases, Si starts to diffuse into the CoSi film, and eventually forms a single low resistance phase CoSi₂.

If the CoSi₂ process solution is used, for the PMOS region, especially for PMOS with a small line width (line width of the source-drain structure is less than 40 nm), when SiGe is epitaxialized at the source-drain, there is not sufficient Si for reacting with Co due to the reduction of the Si content in the SiGe epitaxial structure with respect to the pure Si content, resulting in not sufficient Si for reacting with Co, which increases the temperature required to form the low resistance phase CoSi₂. When the temperature is too high, CoSi₂ is prone to agglomeration, resulting in line breakage and affecting the quality of the product.

For logic circuits with technical nodes less than 28 nm, most semiconductor companies begin to develop in the direction of NiSi, but since NiSi at the higher temperature (>650 °C) begins to undergo a phase transition, and become a high resistance phase NiSi₂, therefore, the requirements of a latter process after forming the NiSi film to be less than 650°C, if the latter process needs a high temperature, the NiSi alloy is difficultly used, that is, the CoSi₂ process solution is still required for the processes requiring high temperatures.

Based on this, a new process solution is needed to solve the problem of insufficient Si content in the SiGe epitaxial structure of the source-drain of the PMOS with a small line width, in order to ensure the formation of a low resistance phase CoSi₂ on the surface of the SiGe epitaxial structure.

### SUMMARY

Accordingly, the present application provides a method of preparing a PMOS transistor, in accordance with claims which follow.

According to a first aspect of embodiments of the present application, there is provided a method of preparing a positive channel Metal Oxide Semiconductor (PMOS) transistor, the method is applicable to the fabrication of the PMOS transistor, a source-drain structure of the PMOS transistor has a line width less than 40 nm, the method includes:
providing a substrate, and forming source-drain trenches on the substrate;
growing SiGe material within the source-drain trenches to form a SiGe layer, and growing a Si thin film layer on the surface of the SiGe layer to form a stacked layer structure of the SiGe layer and the Si thin film layer; and
growing a first Co thin film layer on the stacked layer structure, and performing an annealing treatment, to make Co in the first Co thin film layer react with Si in the Si thin film layer to form a first CoSi₂ thin film layer;
an overall structure formed within the source-drain trenches is a source-drain, and the first CoSi₂ thin film layer is an upper structure of the source-drain.

In an embodiment, the method further includes:
preparing a first gate layer on the substrate, the first gate layer is made of polysilicon; and
growing a second Co thin film layer on the first gate layer, and performing the annealing treatment, to make Co in the second Co thin film layer react with Si in the first gate layer to form a second CoSi₂ thin film layer;
an overall structure of the first gate layer and the second CoSi₂ thin film layer is a first gate, and the second CoSi₂ thin film layer is an upper structure of the first gate.

In an embodiment, the first Co thin film layer and the second Co thin film layer are grown simultaneously, and then performed by the annealing treatment, and the first CoSi₂ thin film layer and the second CoSi₂ thin film layer generated by reaction are the upper structure of the source-drain and the upper structure of the first gate, respectively.

In an embodiment, in a process of growing the Si thin film layer on the surface of the SiGe layer, a thickness of the Si thin film layer is satisfied:
in a subsequent reaction with the first Co thin film layer to generate the first CoSi₂ thin film layer, all Si contained in the Si thin film layer is consumed by Co and there is no insufficient Si, and the insufficient Si means that remaining Co is still unreacted after the annealing treatment.

In an embodiment, the thickness of the Si thin film layer is less than 20 nm.

According to a second aspect of embodiments of the present application, there is provided a PMOS transistor, prepared by the method as mentioned above of preparing the PMOS transistor.

According to a third aspect of embodiments of the present application, there is provided a CMOS circuit, which includes:
a substrate;
at least one N-Metal-Oxide-Semiconductor (NMOS) transistor formed on the substrate; and
at least one PMOS transistor as mentioned above formed on the substrate.

In an embodiment, the NMOS transistor includes:
an active region, including a source-drain region for forming a source-drain of the NMOS transistor;
a second gate dielectric layer formed on the active region; and
a second gate formed on the second gate dielectric layer, the source-drain regions are provided on two sides of the second gate, and the second gate includes a second gate layer;
the second gate layer is made of polysilicon.

According to a fourth aspect of embodiments of the present application, there is provided a method of preparing a CMOS circuit, applied for manufacturing the CMOS circuits as mentioned above, including:
providing the substrate, and forming at least two active regions on the substrate, wherein two adjacent active regions are separated by a shallow trench isolation structure;
forming the source-drain trenches of the PMOS transistor within each active region corresponding to the PMOS transistor;
growing SiGe material within the source-drain trenches of the PMOS transistor to form the SiGe layer, and growing the Si thin film layer on a surface of the SiGe layer to form the stacked layer structure of the SiGe layer and the Si thin film layer; and
growing the first Co thin film layer on the surface of the stacked layer structure, and performing an annealing treatment, to make Co in the first Co thin film layer react with Si in the Si thin film layer to form the first CoSi2 thin film layer.

In an embodiment, the N-Metal-Oxide-Semiconductor (NMOS) transistor includes:
the active region, comprising the source-drain region for forming the source-drain of the NMOS transistor;
the second gate dielectric layer formed on the active region; and
the second gate formed on the second gate dielectric layer, wherein the source-drain regions are provided on two sides of the second gate, and the second gate comprises a second gate layer;
the first gate layer and the second gate layer are both made of polysilicon.

In an embodiment, the method includes:
providing the substrate, and forming at least two active regions on the substrate, wherein two adjacent active regions are separated by the shallow trench isolation structure;
forming the first gate layer of the PMOS transistor and the second gate layer of the NMOS transistor simultaneously on each active region;
forming the source-drain trenches of the PMOS transistor within the active region corresponding to the PMOS transistor;
growing the SiGe material within the source-drain trenches of the PMOS transistor to form the SiGe layer, and growing the Si thin film layer on the surface of the SiGe layer to form the stacked layer structure of the SiGe layer and the Si thin film layer; and
simultaneously growing the first Co thin film layer, the second Co thin film layer, a third Co thin film layer, and a fourth Co thin film layer on the stacked layer structure, on the first gate layer, on the second gate layer, and on the source-drain region of the NMOS transistor, respectively; and
performing the annealing treatment to make the first Co thin film layer, the second Co thin film layer, the third Co thin film layer and the fourth Co thin film layer react with corresponding Si to generate the first CoSi₂ thin film layer, the second CoSi₂ thin film layer, a third CoSi₂ thin film layer and a fourth CoSi₂ thin film layer, respectively.

### BRIEF DESCRIPTION OF THE DRAWINGS

FIGS. 1 and 2 are sectional views of the PMOS transistor formed with a cobalt silicide in the related art.
FIGS. 3 and 4 are flowcharts of a method of preparing a PMOS transistor of an embodiment of the present application.
FIGS. 5 to 11 are sectional structure views of the PMOS transistor during a formation process in an embodiment of the present application.
FIGS. 12 to 22 are sectional structure views of a CMOS circuit during a formation process in an embodiment of the present application.
FIGS. 23 and 24 are flowcharts of a method of preparing the CMOS circuit of an embodiment of the present application.

### DETAILED DESCRIPTION OF THE EMBODIMENTS

In order to make the objects, technical solutions and advantages of the present application clearer and more understandable, the present application is described in further detail hereinafter in connection with the accompanying drawings and embodiments. Examples of the described embodiments are shown in the accompanying drawings, the same or similar labels throughout indicate the same or similar elements or elements having the same or similar functions. The embodiments described below by reference to the accompanying drawings are exemplary and are intended only for the purpose of explaining the present application and are not to be construed as a limitation of the present application. Furthermore, it should be understood that the specific embodiments described herein are for the sole purpose of explaining the present application and are not intended to limit the present application.

In the description of the present application, it is to be understood that the orientation or positional relationships indicated in the description of the orientation and positional relationships are based on those shown in the accompanying drawings only for the purpose of facilitating the description of the present application and simplifying the description, and are not indicative of or suggestive of the need for the device or element referred to be of a particular orientation or to be constructed and operated with a particular orientation, and therefore are not to be construed as a limitation of the present application.

Furthermore, the terms "first" and "second" are used only for descriptive purposes and are not to be understood as indicating or implying relative importance or implicitly specifying the number of technical features indicated. As a result, the features defined with "first", "second" may expressly or implicitly include one or more of the features. In the description of the present application, "more than one" means two or more, unless otherwise expressly and specifically limited.

The following disclosure provides a number of different embodiments or examples for implementing different structures of the present application. In order to simplify the disclosure of the present application, the components and settings of particular examples are described below. They are, of course, only examples and are not intended to limit the present application. In addition, the present application may repeat reference numerals and/or reference letters in different examples, such repetition is for the purpose of simplification and clarity and itself is not indicative of a relationship among the various embodiments and/or settings discussed. In addition, various specific examples of processes and materials are provided in the present application, but those skilled in the art may realize the application of other processes and/or the use of other materials.

As can be seen from the above background technology section, (1) the solution of the related art cannot be adapted to the latter high temperature process if the NiSi process is used; (2) the small line width effect existing in the CoSi₂ process cannot be solved in the case the conventional structure CoSi₂ process is used; and (3) for a source-drain region of the PMOS transistor, the formation of the CoSi₂ on the surface of the SiGe process requires a novel SiGe process to solve the problem of insufficient Si content in SiGe epitaxial structures.

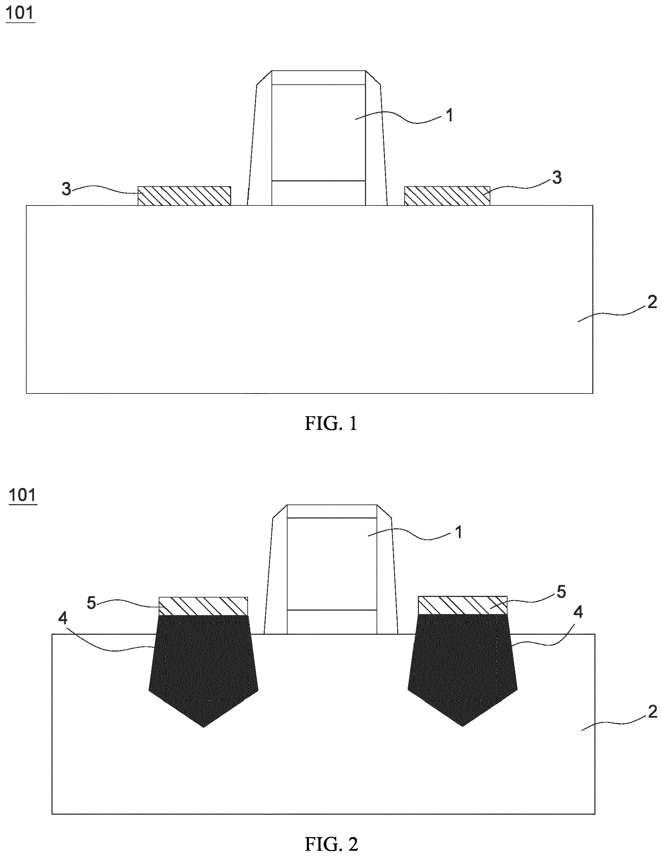

Referring to FIGS. 1 and 2, the above mentioned (3) is taken as an example in combination with the structure of the conventional PMOS transistor 101 and the conventional process procedure of the PMOS transistor 101.

As shown in FIG. 1, in the conventional CoSi₂ process, a Co film is directly deposited on the surface of the substrate 2 on two sides of the gate structure 1 to react with the Si in the substrate 2. Since the Si content in the substrate 2 is high, and the source-drain regions of the PMOS transistor have not been deposited with SiGe, and the small line width effect does not exist, the Co film can directly react sufficiently with the substrate 2 to form the low resistance phase CoSi₂ layer 3 to satisfy the usage requirements.

As shown in FIG. 2, if the SiGe layer 4 is epitaxially formed in the substrate 2 on two sides of the gate structure 1 to enhance the compressive stress on the PMOS transistor 101, then in the process of the Co thin film being deposited on the surface of the SiGe layer 4 for reaction to form the cobalt silicide, the high resistance phase Si₂Co layer or SiCo layer 5 can only be formed, due to the low Si content in the SiGe layer 4 and the small line width effect, only high resistance phase Si₂Co layer or SiCo layer can be formed, thereby affecting the performance of the PMOS transistor 101.

Unlike the related art, the technical solution of the present application increases the Si epitaxy when the SiGe epitaxy is ended and controls the thickness of the Si epitaxy, so that Co is fully consumed when reacting with the Si fto form the low resistance phase CoSi₂, which not only ensures that there is sufficient Si in the process of forming the CoSi₂, but also ensures that the low resistance phase CoSi₂ does not increase the resistances at the source-drain, ensuring performance of the PMOS transistor.

That is, the present scheme ensures the provision of stress to the PMOS by epitaxially forming SiGe in the substrate 10, such that improving the carrier mobility. The present scheme also provides sufficient Si for the subsequent cobalt silicide process to form the low resistance phase CoSi₂ by epitaxializing Si on SiGe, such that the processes of the PMOS transistor and the SiGe epitaxy are efficiently optimized.

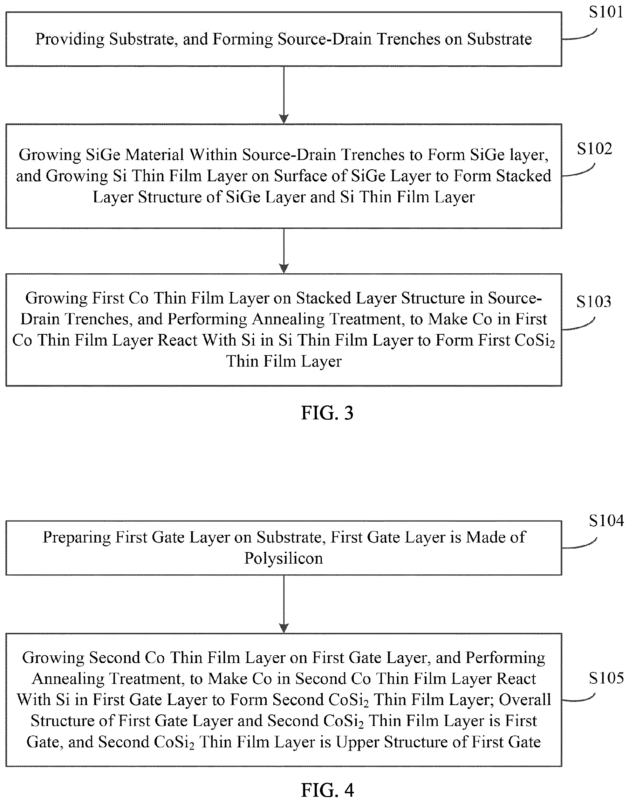

Referring to FIG. 3 and FIGS. 5 to 11, the method for preparing the PMOS transistor 100 of an embodiment of the present application is applicable to the fabrication of the PMOS transistor 100, ssource-drain structure of the PMOS transistor have line widths less than 40 nm.

Specifically, as shown in FIG. 3, the method includes:
step S101: providing a substrate 10, and forming source-drain trenches 11 on the substrate 10;
step S102: growing SiGe material within the source-drain trenches 11 to form a SiGe layer 30, and growing a Si thin film layer 40 on a surface of the SiGe layer 30 to form a stacked layer structure of the SiGe layer 30 and the Si thin film layer 40; and
step S103: growing a first Co thin film layer 50 on the stacked layer structure in the source-drain trenches 11, and performing an annealing treatment, to make Co in the first Co thin film layer 50 react with Si in the Si thin film layer 40 to form a first CoSi₂ thin film layer 60;
an overall structure formed within the source-drain trenches 11 is a source-drain, and the first CoSi₂ thin film layer 60 is an upper structure of the source-drain 11.

Specifically, in step S101, the material of the substrate 10 may be monocrystalline silicon (Si), monocrystalline germanium (Ge), silicon-germanium (GeSi), or silicon carbide (SiC), or silicon on insulator (SOI), germanium on insulator (GOI); or other materials, such as III-V compounds such as gallium arsenide.

In this embodiment, the material of the substrate 10 is monocrystalline silicon (Si).

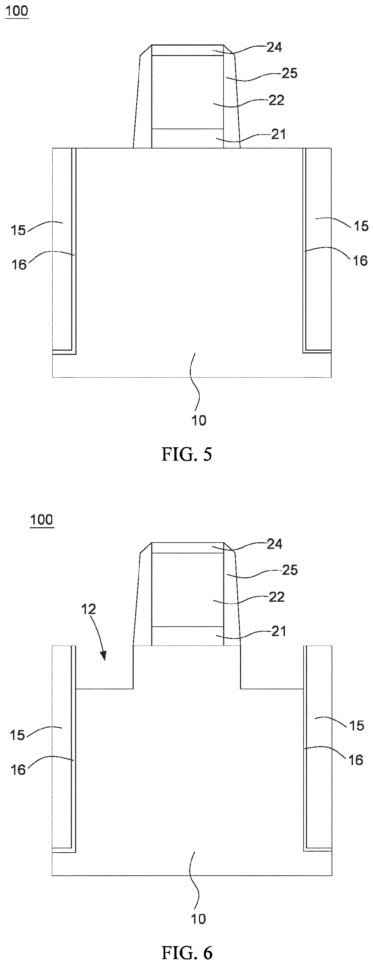

Please refer to FIGS. 5 to 7, exemplarily, the step of forming the source-drain trenches 11 in step S101 may specifically include:
S1011: patterning the substrate 10;
S1012: forming an opening 12 in the substrate 10 (the opening 12 may be a U-shaped trench for the source-drain as shown in FIG. 6);
S1013: etching the substrate 10 along the opening 12 to form the source-drain trenches 11.

In one embodiment, the process for forming the above mentioned opening 12 may be a dry etching or wet etching.

In one embodiment, the shape of the source-drain trench 11 may be square, U-shaped, or sigma-shaped (Σ).

More preferably, in a conventional process, the shape of the source-drain trench 11 is sigma-shaped.

Specifically, the sigma-shaped source-drain trench 11 has sidewalls concave inwardly towards the device channel, such shape can effectively shorten the length of the device channel to meet the requirement of miniaturization of size of the device.

Moreover, the sigma-shaped source-drain trench 11 has a larger undercut below the gate gap body, and the formation of stress material within this shape of the source-drain trench 11 can generate greater stress on the device channel region.

In one embodiment, the process for forming the source-drain trenches 11 may be a dry etching, a wet etching, or a combination of dry etching and wet etch etching.

Exemplarily, the formation of the sigma-shaped source-drain trench 11 is illustrated:

A reactive ion etching (RIE) dry etching process may be used to etch the substrate 10 along the opening 12 to form an inverted trapezoidal pre-source-drain trench, after which a wet etching process is performed using tetramethylamine (TMAH) or ammonia (NH₄OH) to continue to etch the pre-source-drain trench to form the sigma-shaped source-drain trench 11.

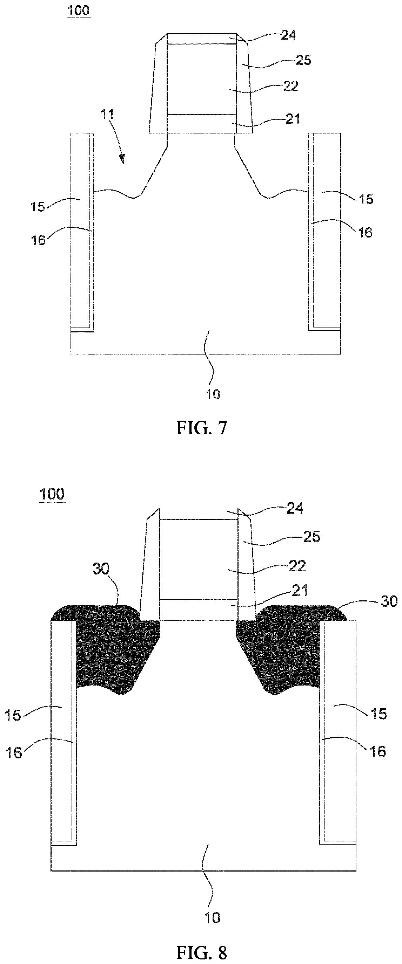

As shown in FIG. 7, due to the limitations of other structures in the substrate 10 (e.g., the shallow trench isolation structure 15 and the liner 16 as below), the shape of the source-drain trench 11 in the embodiment of the present application is not square, U-shaped, or sigma ( Σ )-shaped, but partially sigma-shaped, such that the portion of the source-drain trench 11 that is closer to the gate is sigma-shaped, and other portions of the trench 11 are irregularly shaped.

Please combine FIG. 7 with FIG. 8, in step S102, after the substrate 10 is etched to form the source-drain trenches 11, a SiGe layer 30 is grown fully within the source-drain trenches 11.

The SiGe layer 30 may be a single-layer structure or a multilayer structure, which may increase the stress acting on the channel region of the PMOS transistor 100, thereby increasing the carrier mobility of the PMOS transistor 100 and optimizing the performance of the PMOS transistor 100.

In one embodiment, the SiGe layer 30 may be formed using a selective epitaxial process.

In one embodiment, after the sigma-shaped source-drain trench 11 is fully filled with SiGe, the SiGe layer 30 may be substantially in the shape of a positive hexagon.

As shown in FIG. 7, since the source-drain trench 11 in this embodiment is not completely sigma-shaped, the SiGe layer 30 formed epitaxially in the source-drain trenches 11 is also not in the shape of the positive hexagon, but as shown in FIG. 8, the top and one side of the SiGe layer 30 has a relatively distinct positive hexagonal contour, and it still has the function of the SiGe layer that is in the shape of the positive hexagon in the conventional process.

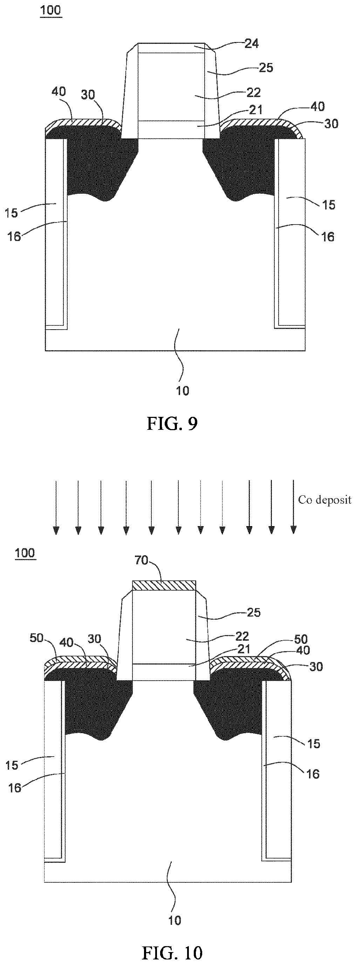

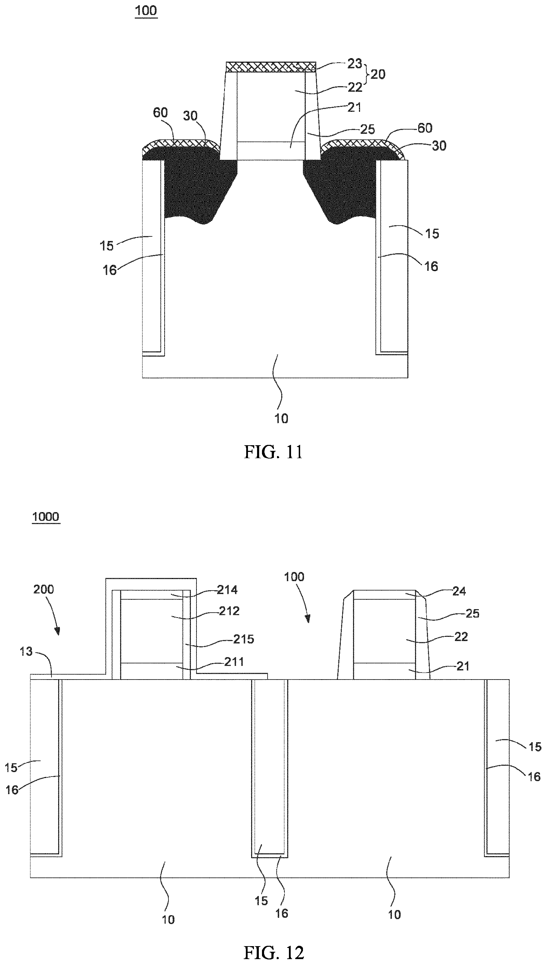

It is understood that before forming the first CoSi₂ thin film layer 60, Si film and Co film are formed first, therefore, referring to FIG. 9, the present embodiment first forms a set thickness of a Si thin film layer 40 on the surface of the SiGe layer 30 by step S102, as shown in FIGS. 10 and 11, and then forms a first Co thin film layer 50 on the Si thin film layer 40 in the subsequent step S103, to make the Si thin film layer 40 react with the first Co thin film layer 50 by the annealing reaction to form the first CoSi₂ thin film layer 60.

The set thickness of the Si thin film layer 40 is guaranteed to be fully consumed during the reaction process, which not only ensures sufficient Si during the formation of the first CoSi2 thin film layer, but also avoids the excess Si from increasing the resistance at the source and drain.

It can be understood that if the thickness of the Si thin film layer 40 is too small, in the subsequent reaction process with the first Co thin film layer 50, there will not be sufficient Si to react with Co, thereby affecting the formation of the low resistance phase CoSi₂, and then affecting the performance of the PMOS transistor 100.

If the thickness of the Si thin film layer 40 is too large, although it does not affect the conversion of the silicon cobalt silicide into the low resistance phase CoSi₂, it will have the following effects: first, the reaction with Co takes too long, and the first Co thin film layer 50 to be deposited is too much, which is not conducive to the efficiency of the formation of the PMOS transistor 100. Second, the first CoSi₂ thin film layer 60 formed by the reaction is thicker, which not only affects the size of the PMOS transistor 100, but also leads to too much loss of Si in the source-drain region, and the current leakage of the device will increase, thereby affecting the performance of the PMOS transistor.

Therefore, in the process of growing the Si thin film layer 40 on the surface of the SiGe layer 30 in step S102, a preferred embodiment is that the thickness of the Si thin film layer 40 satisfies the following conditions:

When the above Si thin film layer 40 is subsequently reacted with the first Co thin film layer 50 to generate the first CoSi₂ thin film layer 60, all Si contained in the Si thin film layer 40 is consumed by Co and there is no insufficient supply of Si, and the insufficient supply of Si can be understood to mean that there is still remaining Co that is not reacted after the annealing treatment, that is, the Si is fully reacted with the Co and there is no residue of Si and Co.

Further, in step S102, the thickness of the Si thin film layer 40 deposited on the surface of the SiGe layer 30 is less than 20 nm.

More preferably, the thickness of the Si thin film layer 40 is about 12 nm.

In one embodiment, the Si thin film layer 40 may be formed using a selective epitaxial process.

In one embodiment, the first Co thin film layer 50 may be formed on the surface of the Si thin film layer 40 by physical vapour deposition.

In another embodiment, the first Co thin film layer 50 may also be formed on the surface of the Si thin film layer 40 by magnetron sputtering.

In this embodiment, the first Co thin film layer 50 is formed by physical vapour deposition. It will be appreciated that any suitable process may be employed to form the Si thin film layer 40 and the first Co thin film layer 50.

Please refer to FIG. 10 and FIG. 11, after depositing the first Co thin film layer 50 on the surface of the Si thin film layer 40, the Si thin film layer 40 is made to react with the first Co thin film layer 50 to form the first CoSi₂ thin film layer 60.

Generally, the Si thin film layer 40 may be made to react with the first Co thin film layer 50 to form the first CoSi₂ thin film layer 60 by a process such as heat treatment, e.g., laser annealing, and the temperature of the heat treatment may be from 500° C to 750° C.

In the embodiment of the present application, the overall structure formed within the source-drain trenches 11 is the source-drain of the PMOS transistor 100, and the first CoSi₂ thin film layer 60 is the upper structure of the source-drain, i.e., the source-drain includes the SiGe layer 30 in the source-drain trenches 11 and the first CoSi₂ thin film layer 60 thereon, and a distance between the source and the drain is less than 40 nm.

It should be noted that the gate 20 may be formed on the surface of the substrate 10 first, and then the source-drain trenches 11 may be formed in the substrate 10 on two sides of the gate 20 before other subsequent processing.

In the method for preparing the PMOS transistor 100 of the embodiment of the present application, the SiGe layer 30 is formed by first performing SiGe epitaxy in the substrate 10, and a difference of the lattice constants of the SiGe from the lattice constants of the Si in the substrate 10 is used to enhance the stresses acting in the channel region, provide compressive stresses for the PMOS transistor 100, and improve the carrier mobility of the PMOS transistor 100.

On the other hand, compared with the Si material, the Ge material itself has a higher carrier mobility, which can improve the driving current of the PMOS transistor 100, thereby improving the electrical performance of the PMOS transistor 100. The Si thin film layer 40 is epitaxialized after the SiGe is epitaxialized to a certain thickness, which provides sufficient Si to for the subsequent CoSi₂ process form the first CoSi₂ thin film layer 60, and avoids the problem of CoSi₂ agglomeration caused by the need to increase the reaction temperature in order to convert the cobalt silicide into the low resistance phase CoSi₂, such that the processes of PMOS transistor and SiGe epitaxy are optimized.

Referring to FIG. 4, FIG. 10 and FIG. 11, the method of preparing the PMOS transistor of the embodiment of the present application further includes:

S104: preparing the first gate layer 22 on the substrate 10, the first gate layer 22 is made of polysilicon;

S105: growing the second Co thin film layer 70 on the first gate layer 22, and performing the annealing treatment, to make Co in the second Co thin film layer 70 react with Si in the first gate layer 22 to form the second CoSi₂ thin film layer 23;

an overall structure of the first gate layer 22 and the second CoSi₂ thin film layer 23 is a first gate 20, and the second CoSi₂ thin film layer 23 is an upper structure of the first gate 20.

Alternatively, in the embodiment of the present application, the first Co thin film layer 50 and the second Co thin film layer 70 are grown simultaneously, and then performed by the annealing treatment, as shown in FIG. 11, and the first CoSi2 thin film layer 60 and the second CoSi2 thin film layer 23 generated by the reaction are the upper structure of the source-drain and the upper structure of the gate 20 of the PMOS transistor, respectively.

How to prepare the first gate layer 22 on the substrate 10 is a well-established technique in the art, which will not be repeated herein.

Conventionally, a first gate dielectric layer 21 is first formed on the surface of the substrate 10, and the first gate 20 may include a first gate layer 22 formed on the surface of the first gate dielectric layer 21 and a second CoSi₂ thin film layer 23 formed on the surface of the first gate layer 22.

Specifically, the material of the first gate dielectric layer 21 may be SiO₂ or a High-k dielectric material. The High-k dielectric material may be one or a combination of HfO₂, HfSiO, HfSiON, HfTaO, HfTiO, HfZrO, ZrO₂, Al₂O₃, HfO₂-Al₂O₃ alone.

In one embodiment, the process for forming the first gate dielectric layer 21 may be chemical vapour deposition (CVD), atomic layer deposition (ALD) or physical vapour deposition (PVD).

It will be appreciated that any suitable material and deposition process may be used to form the first gate dielectric layer 21.

In this embodiment, the first gate layer 22 is made of polysilicon.

In one embodiment, the process for forming the first gate layer 22 may be chemical vapour deposition (CVD), atomic layer deposition (ALD) or physical vapour deposition (PVD).

It will be appreciated that any suitable material and deposition process may be used to form the first gate layer 22.

In addition, the line width of the first gate 20 in this embodiment is less than 40 nm, i.e., the line width of the first gate layer 22 is less than 40 nm, the size of the first gate 20 is controlled, and thus the size of the entire PMOS transistor 100 is controlled.

Moreover, as is known to those skilled in the art, when the line width of the first gate 20 is less than 40 nm, the resistance due to the line width effect is high, and the resistance between the gate and the source and the drain can be controlled by forming the first CoSi₂ thin film layer 60 of a low resistance phase while enhancing the performance of the device.

In the conventional process of the PMOS transistor 100, a mask layer is formed on the surface of the first gate 20, i.e., a mask layer is formed on the surface of the first gate layer 22, whereas the embodiment of the present application differs from the conventional process in that the mask layer on the first gate 20 is removed, and instead, a second CoSi₂ thin film layer 23 is formed on the surface of the first gate layer 22, which increases the conductivity between the metal conductor and the polycrystalline silicon gate, thereby promoting ohmic contact.

It will be appreciated that since the first gate layer 22 in this embodiment is made of polycrystalline silicon, when the second Co film layer 70 is deposited on the surface of the first gate layer 22, there is sufficient Si in the first gate layer 22 that can react with the second Co film layer 70 to form the second CoSi₂ film layer 23.

Moreover, the deposition of the second Co thin film layer 70 on the surface of the first gate layer 22 is performed in the same step as the deposition of the first Co thin film layer 50 on the surface of the Si thin film layer 40, which improves the production efficiency of the PMOS transistor 100.

Please refer to FIGS. 5 to 11, the PMOS transistor 100 of the embodiment of the present application is prepared by using the method of preparing the PMOS transistor 100 of any of the above embodiments.

In the PMOS transistor 100 of the embodiments of the present application, the beneficial effects and specific structural composition and description, etc., brought about by the method of preparing the PMOS transistor 100 of any of the above embodiments refer to the above contents about the method of preparing the PMOS transistor 100, which will not be repeated herein.

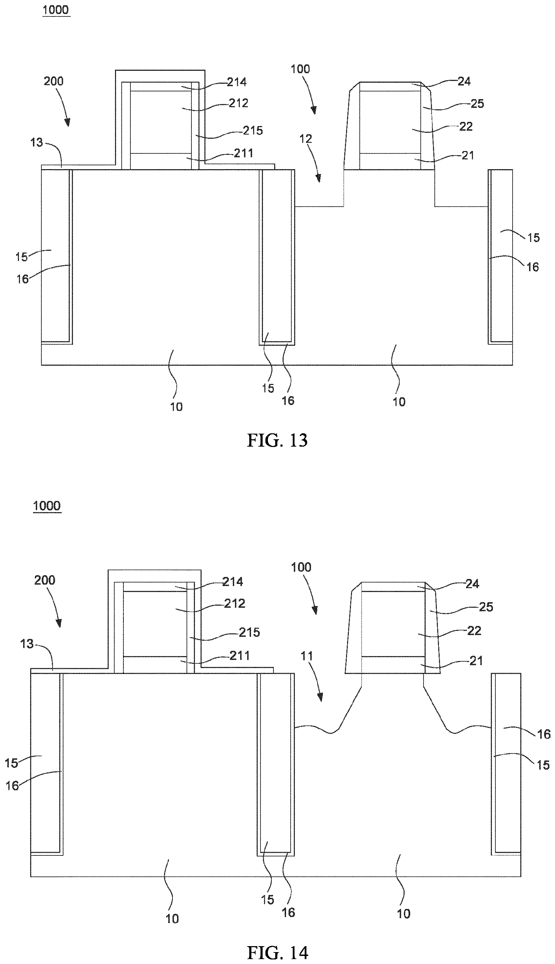

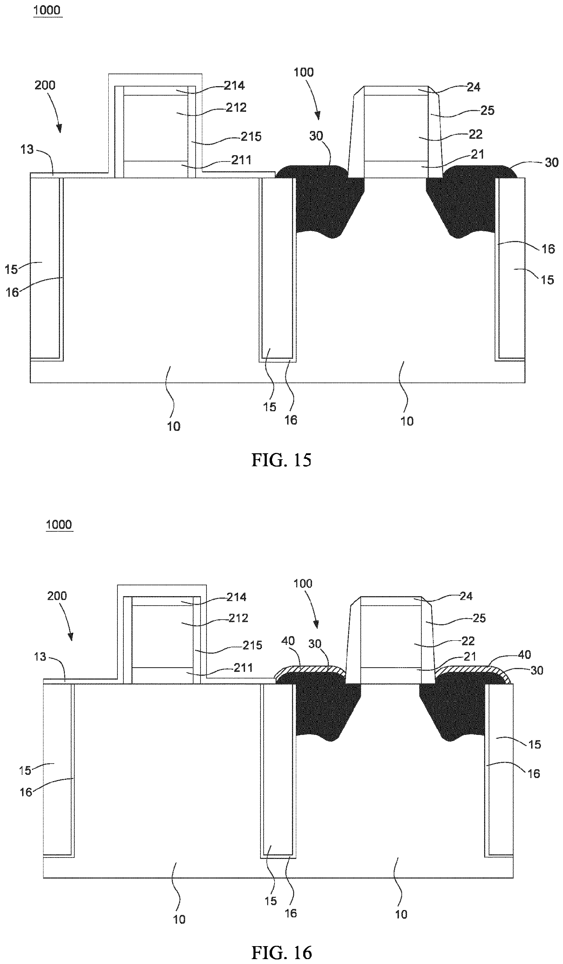

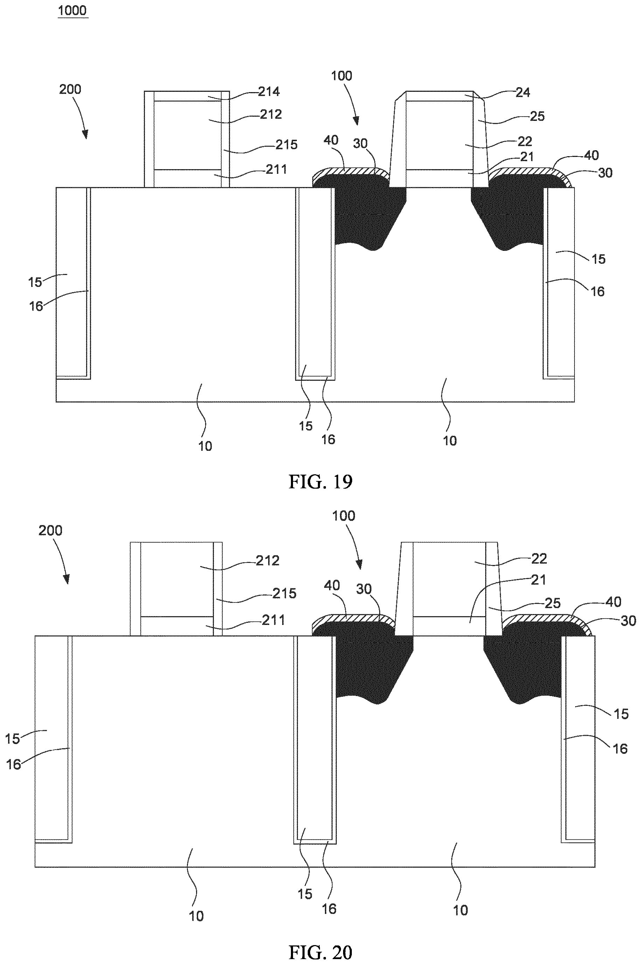

Referring to FIGS. 12 to 22, the CMOS circuit 1000 of the embodiment of the present application includes:
at least one NMOS transistor 200 formed on the substrate 10; and
at least one PMOS transistor 100 formed on the substrate 10 according to any of the above embodiments.

In the CMOS circuit 1000 of the embodiment of the present application, the beneficial effects and specific structural composition and description, etc., brought about by the PMOS transistor 100 according to each of the above embodiments refer to above contents about the PMOS transistor 100, which will not be repeated herein.

The CMOS circuit 1000 includes the PMOS transistor 100 and the NMOS transistor 200, which are also well known to those skilled in the art, and their operating principles and related structural features are not discussed herein.

The following section will focus on the contents of portion of the NMOS transistor 200 of the CMOS circuit 1000, and the portion of the preparation of the PMOS transistor 100 that is related to the preparation of the NMOS transistor.

The NMOS transistor 200 is a conventional planar transistor, and for the contents relating to the source-drain, please refer to the above contents relating to the formation of the source-drain in the PMOS transistor 100, and the difference lies in the difference in ion implantation.

Referring to FIGS. 5 to 11, moreover, each of two sides of the first gate 20 in this embodiment is provided with a first sidewall 25, the first sidewalls 25 are provided on a surface of the substrate 10 and affixed to the surfaces of two sides of the first gate 20.

In this embodiment, the first sidewalls 25 are used to protect the sidewalls of the first gate 20 from damage when etching or ion implantation is subsequently performed, thereby ensuring the performance of the first gate 20.

The first sidewall 25 can be made of silicon oxide, silicon carbide, silicon nitride, or silicon nitride oxide, etc.

In one embodiment, the first sidewall 25 may be a stacked layer structure of silicon oxide-silicon nitride, or a stacked layer structure of silicon nitride-silicon oxide-silicon nitride, or a stacked layer structure of silicon oxide-silicon nitride-silicon oxide.

In one embodiment, the formation process of the first sidewall 25 may be chemical vapour deposition (CVD), atomic layer deposition (ALD) or physical vapour deposition (PVD).

It will be appreciated that any suitable material and deposition process may be used to form the first sidewall 25.

Alternatively, before forming the first sidewall 25, a low doped drain (LDD) may be formed within the substrate 10 on each side of the gate 20 to prevent thermoelectronic degradation effects.

Please refer to FIGS. 5 to 9, before the second Co film layer 70 is grown on the surface of the first gate layer 22, and the first gate mask layer 24 is formed on the surface of the first gate layer 22, and furthermore, the preparation step S105 of the first gate 20 of the embodiment of the present application may specifically include:
S1051: removing the first gate mask layer 24 to expose the upper surface of the first gate layer 22; and
S1052: growing a second Co thin film layer 70 on the surface of the first gate layer 22, and then preforming an annealing treatment, to make Co in the second Co thin film layer 70 react with Si in the first gate layer 22 to form a second CoSi₂ thin film layer 23.

In a conventional process, the material of the first gate mask layer 24 may be silicon nitride, which can effectively protect the first gate layer 22 from being destroyed in the process because silicon nitride does not react with inorganic acids other than hydrofluoric acid, has a high resistant to corrosion, and is not infiltrated or corroded by many molten metals or alloys such as aluminium, copper or nickel.

In one embodiment, the process for forming the first gate mask layer 24 may be chemical vapour deposition (CVD), atomic layer deposition (ALD) or physical vapour deposition (PVD).

In another embodiment, the process for forming the first gate mask layer 24 may be low pressure atomic layer deposition.

It will be appreciated that any suitable material and deposition process may be used to form the first gate mask layer 24.

Embodiments of the present application differ from conventional processes in that the first gate mask layer 24 on the first gate 20 is removed, and instead, a second CoSi₂ thin film layer 23 is formed on the surface of the first gate layer 22 to increase the conductivity between the metal conductor and the polycrystalline silicon gate, to promote ohmic contact.

Referring to FIGS. 12 to 22, further in this embodiment, a second gate 210 is formed on a surface of an active region of the substrate 10 corresponding to the NMOS transistor 200. A second gate dielectric layer 211 is formed on the surface of the substrate 10 spaced apart from the second gate 210 and the active region, and the second gate 210 specifically includes a second gate layer 212 provided on the surface of the second gate dielectric layer 211 and a third CoSi₂ thin film layer 213 formed on the surface of the second gate layer 212. Additionally, a fourth CoSi₂ thin film layer 216 is formed on the surface of the substrate 10 corresponding to the NMOS transistor 200.

Specifically, the second gate 210 has the same specific structure as the first gate 20, and their materials used and the process steps are basically the same, and the contents about the second gate 210 can refer to above contents about the first gate 20 in the PMOS transistor 100.

A second sidewall 215 is also formed on the each of two sidewalls of the second gate 210, and the contents about the second sidewall 215 may be referred to the above contents about the first sidewall 24, which will not be described herein.

In this embodiment, the second gate mask layer 214 is also removed, and instead, a third CoSi₂ thin film layer 213 is grew on the surface of the second gate layer 212 to react to form a third Co thin film layer 80, and a fourth CoSi₂ thin film layer 216 is formed after a fourth Co thin film layer 90 is grew on the surface of the substrate 10 corresponding to the NMOS transistor 200, so that the conductivity between the metal conductor and the polysilicon gate can be increased by the third CoSi₂ thin film layer 213 and the fourth CoSi₂ thin film layer 216, to promote ohmic contact, thereby enhancing the performance of the device.

The second gate mask layer 214 and the first gate mask layer 24 can be removed in the same step, i.e., the first gate mask layer 24 and the second gate mask layer 214 can be removed simultaneously.

How to remove the gate mask layer is a well-established technique in the field, which will not be described in detail herein.

The third CoSi₂ thin film layer 213 and the fourth CoSi₂ thin film layer 216 can also be formed in the same step as the formation of the first CoSi₂ thin film layer 60 and the second CoSi₂ thin film layer 23.

That is, the Co thin film layer may be deposited onto the entire CMOS circuit 1000 after the first gate mask layer 24 and the second gate mask layer 214 are removed, so that the Co thin film is deposited on the surfaces of the Si thin film layer 40, the first gate layer 22, the second gate layer 212, and the source-drain region of the NMOS transistor 200, respectively, for reaction, thereby forming the first CoSi₂ thin film layer 60, the second CoSi₂ thin film layer 23, the third CoSi₂ film layer 213, and the fourth CoSi₂ film layer 216 simultaneously or within the same time period, further enhancing the production efficiency of the CMOS circuit 1000.

It is understood that since the second gate layer 212 and the first gate layer 22 in the present embodiment are made of polysilicon, and the substrate 10 is also a silicon substrate 10, thus when the Co thin film layer is deposited on the surface of the second gate layer 212 and on the surface of the source-drain region of the NMOS transistor 200, there is sufficient Si in the second gate layer 212 and in the source-drain region of the NMOS transistor 200 to react with the Co film layer, thereby forming the third CoSi₂ film layer 213 and the fourth CoSi₂ film layer 216.

More, in one embodiment, a SiGe layer 30 may also be formed in the substrate 10 on two sides of the second gate 210 of the NMOS transistor 200 to further enhance the electrical performance of the CMOS circuit 1000.

Specific steps may be referred to the above contents that the SiGe layer 30 is formed on the substrate 10 on two sides of the first gate 20, which will not be described in detail herein.

In the CMOS circuit 1000, for the portion of the PMOS transistor 100, a first gate dielectric layer 21 is formed on the surface of the substrate 10, and the first gate 20 includes a first gate layer 22 on the surface of the first gate dielectric layer 21 and a second CoSi₂ film layer 23 on the surface of the first gate layer 22.

Please refer to FIGS. 12 to 22, for the portion of the NMOS transistor 200, a second gate dielectric layer 211 is formed on the surface of the substrate 10, and the second gate 210 includes a second gate layer 212 on the surface of the second gate dielectric layer 211 and a third CoSi₂ thin film layer 213 on the surface of the second gate layer 212.

In the conventional process, a second gate mask layer 214 is formed on the surface of the second gate layer 212 before the third Co film layer 80 is grew on the surface of the second gate layer 212. In addition, a first mask layer 13 is formed on the surface of the substrate 10 on two sides of the second gate 210.

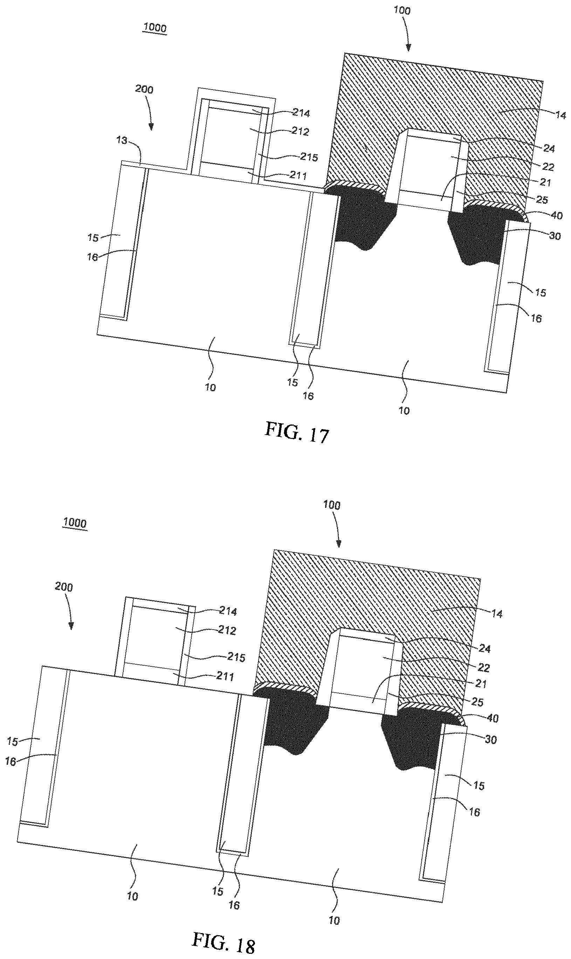

Please refer to FIGS. 17 to 22, based on the above base structure, moreover, after the step S102 of growing the Si thin film layer 40 on the SiGe layer 30 in the preparation process of the PMOS transistor 100, steps may be included:
S106: forming a photoresist layer 14 on the surface of the first gate mask layer 24 and the Si thin film layer 40;
S107: removing the first mask layer 13 to expose a source-drain region of the NMOS transistor 200;
S108: removing the photoresist layer 14 to expose the surface of the first gate mask layer 24 and the surface of the Si thin film layer 40;
S109: removing the first gate mask layer 24 and the second gate mask layer 214 to expose the surface of the first gate layer 22 and the surface of the second gate layer 212; and
S110: depositing a second Co film layer 70, a third Co film layer 80, and a fourth Co film layer 90 on the surface of the first gate layer 22, the surface of the second gate layer 212, and the source-drain region of the NMOS transistor 200, respectively, and then performing annealing treatment to react to form a second CoSi₂ film layer 23, a third CoSi₂ film layer 213, and a fourth CoSi₂ film layer 216, respectively.

In step S201, the first gate mask layer 24 and the Si film layer 40 are first covered with photoresist to avoid damaging the Si film layer 40 when the first mask layer 13 is removed from the surface of the substrate 10. The first mask layer 13 may be formed during the process of forming the first gate 20 on the substrate 10, and the material and composition of the first mask layer 13 may be referred to the above contents about the material and composition of the first gate mask layer 24, which is not be described in detail herein.

In one embodiment, the process for removing the photoresist layer 14 may be a wet cleaning or a graying process.

If the photoresist layer 14 is removed by a graying process, after the graying process is completed, there is residual photoresist on the surface of the substrate 10 and by-products of the graying process, and the wet cleaning of the surface of the substrate 10 is also required.

Therefore, the photoresist layer 14 on the first gate mask layer 24 and the Si thin film layer 40 is exemplarily illustrated in this embodiment by using wet cleaning to remove the photoresist layer 14.

Specifically, the wet chemical substance that may be used for the wet cleaning is an aqueous solution of ammonia and hydrogen peroxide, and the CMOS circuit 1000 having the photoresist layer 14 on the surface is placed in the reaction chamber, and the photoresist layer 14 is removed by spraying an aqueous solution of ammonia and hydrogen peroxide to the surface of the photoresist layer 14.

In this embodiment, the first gate mask layer 24 and the second gate mask layer 214 on the second gate 210 are simultaneously removed, and instead, a second CoSi₂ thin film layer 23 is formed on the surface of the first gate layer 22, a third CoSi₂ thin film layer 213 is formed on the surface of the second gate layer 212, and a fourth CoSi₂ thin film layer 216 is formed in the source-drain region of the NMOS transistor 200. The conductivity between the metal conductor and the polycrystalline silicon gate is increased by the second CoSi₂ thin film layer 23, the third CoSi₂ thin film layer 213 and the fourth CoSi₂ thin film layer 216, to promote ohmic contact, thereby enhancing the performance of the device.

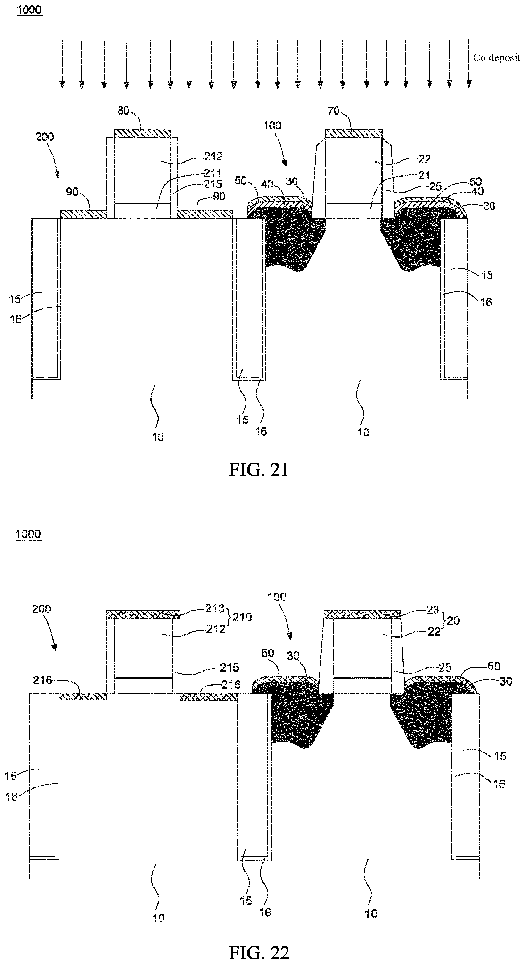

In this embodiment, the second CoSi₂ thin film layer 23, the third CoSi₂ thin film layer 213 and the fourth CoSi₂ thin film layer 216 can be formed in the same step as the formation of the first CoSi₂ thin film layer 60, as shown in FIG. 21, i.e., after removing the first gate mask layer 24 and the second gate mask layer 214, the Co thin film layer is deposited onto the surface of the entire CMOS circuit 1000, so that the Co thin film layer is deposited on the surfaces of the Si thin film layer 40, the first gate layer 22, the second gate layer 212, and substrate 10 in the source-drain region of the NMOS transistor 200, respectively, for reaction, thereby forming the first CoSi₂ thin film layer 60, the second CoSi₂ thin film layer 23, the third CoSi₂ thin film layer 213, and the fourth CoSi₂ thin film layer 216, all simultaneously or within the same time period, thereby further enhancing the production efficiency of the CMOS circuit 1000.

It is understood that since the Si thin film layer 40 in this embodiment is formed by Si epitaxy, the first gate layer 22 and the second gate layer 212 are made of polycrystalline silicon, and the substrate 10 is a silicon substrate, thus when the Co thin film layer is deposited simultaneously on the surfaces of the Si thin film layer 40, the first gate layer 22, the second gate layer 212, and the substrate 10, there is sufficient Si in the Si film layer 40, the first gate layer 22, the second gate layer 212, and the substrate 10 to react with the Co film layer to form the first CoSi₂ film layer 60, the second CoSi₂ film layer 23, the third CoSi₂ film layer 213, and the fourth CoSi₂ film layer 216.

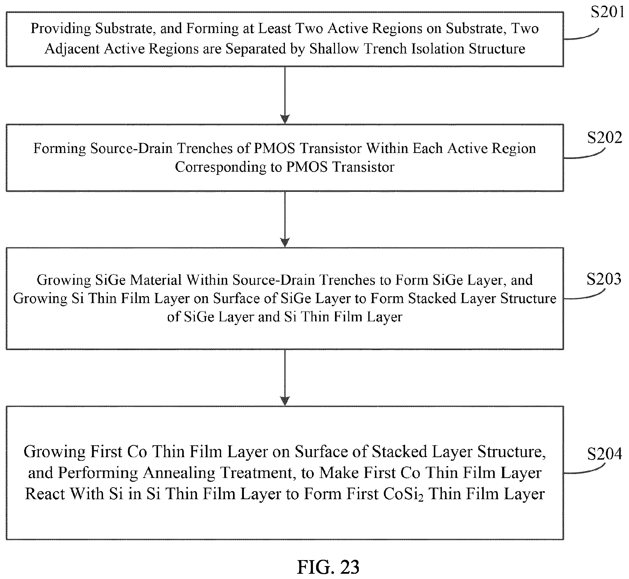

Referring to FIGS. 12 to 23, a method of preparing a CMOS circuit 1000 of an embodiment of the present application is used to fabricate the CMOS circuit 1000 according to any of the above embodiments, the method include:
S201: providing the substrate 10, and forming at least two active regions on the substrate 10, two adjacent active regions are separated by a shallow trench isolation structure 15;
S202: forming source-drain trenches 11 of the PMOS transistor 100 within each active region corresponding to the PMOS transistor 100;
S203: growing SiGe material within the source-drain trenches 11 to form the SiGe layer 30, and growing the Si thin film layer 40 on a surface of the SiGe layer 30 to form the stacked layer structure of the SiGe layer 30 and the Si thin film layer 40; and
S204: growing the first Co thin film layer 50 on a surface of the stacked layer structure, and performing an annealing treatment, to make the first Co thin film layer 50 react with Si in the Si thin film layer 40 to form the first CoSi₂ thin film layer 60.

The specific contents of each step of the method of preparing the CMOS circuit 1000 of the embodiment of the present application and the specific structures involved therein, etc., please refer to the above contents about the preparation of the PMOS transistor 100 and the structural composition of the CMOS circuit 1000, etc., which will not be repeated herein. The new technical features mentioned in the above preparation method will be described accordingly in the following.

Please refer further to FIGS. 12 to 22, in an embodiment of the present application, a plurality of Shallow Trench Isolation (STI) structures 15 are formed on the substrate 10 at spaced intervals, and the shallow trench divides the substrate 10 into a plurality of active regions, and a first gate 20 of the PMOS transistor 100 and a second gate 210 of the NMOS transistor 200 are respectively provided between two adjacent shallow trench isolation structures 15, i.e., the first gate 20 and the second gate 210 are respectively provided on the corresponding active regions.

Specifically, the shallow trench isolation structure 15 may be formed by first etching a shallow trench at a set position on the substrate 10, and then filling the shallow trench with an insulating material.

The insulating material may be one or more of a silicon oxide, a silicon nitride, a silicon nitride, and silicon dioxide.

In this embodiment, the material filled in the shallow trench isolation structure 15 is silicon dioxide.

Unlike the conventional process, there also is a lining 16 formed between the shallow trench isolation structure 15 and the substrate 10 in the present embodiment of the application, and the SiGe layer 30 is in contact with a side of the lining 16. The lining 16 is mainly used to isolate the shallow trench isolation structure 15 from the SiGe layer 30 and prevent the SiGe layer 30 from extending into the substrate 10 of an adjacent transistor when the SiGe layer 30 is formed epitaxially in the source-drain trenches 11.

Exemplarily, an insulating isolation material, such as one or more of monox, silicon nitride, silicon nitride, silicon oxynitride, and silicon dioxide, is formed on the substrate 10 after the shallow trench is formed in the lining 16, so that a set thickness of the insulating isolation material adheres to the shallow trench, and then a remaining space of the shallow trench is sequentially filled with the insulating material to form the shallow trench isolation structure 15, so that the lining 16 is located between the substrate 10 and the shallow trench isolation structure 15.

In one embodiment, the lining 16 may be a thermally oxidised layer, which may be formed by a furnace tube thermal oxidation process.

In addition, since the SiGe layer 30 is in contact with the lining 16 in the substrate 10, thus the portion of the SiGe layer 30 on the surface of the substrate 10 extends to cover a portion of the surface of the shallow trench isolation structure 15, which can increase the volume and surface area of the SiGe layer 30, thereby increasing the volume and surface area of the first CoSi₂ thin film layer 60 formed on the surface of the SiGe layer 30, for increasing the contact area.

On the basis of preparing the above CMOS circuit 1000, furthermore, the NMOS transistor 200 may specifically include:
the active region, including the source-drain region for forming the source-drain of the NMOS transistor 200;
the second gate dielectric layer 211 formed on the active region; and
the second gate 210 formed on the second gate dielectric layer 211, the source-drain regions are provided on two sides of the second gate 210, and the second gate 210 includes the second gate layer 212; the second gate layer and the first gate layer are both made of the same material, that is polysilicon.

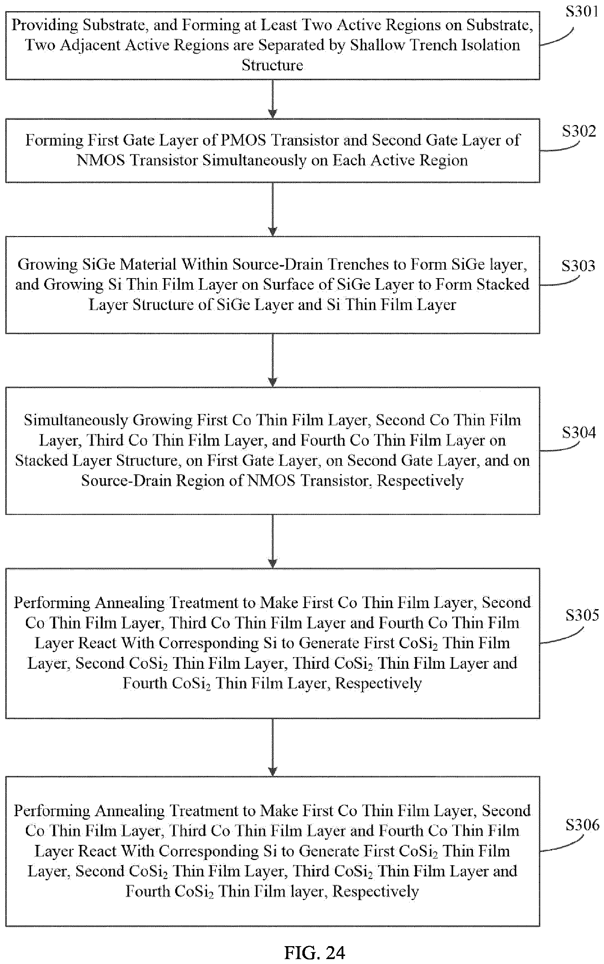

On the basis of the structure of above NMOS transistor 200, please refer to FIG. 12 to 22, and FIG. 24, and another embodiment of the present application of the method of preparing the CMOS circuit 1000 may include:
S301: providing the substrate 10, and forming at least two active regions on the substrate 10, two adjacent active regions are separated by the shallow trench isolation structure 15;
S302: forming the first gate layer 22 of the PMOS transistor 100 and the second gate layer 212 of the NMOS transistor 200 simultaneously on each active region;
S303: forming the source-drain trenches 11 of the PMOS transistor 100 within the active region corresponding to the PMOS transistor 100;
S304: growing the SiGe material within the source-drain trenches 11 to form the SiGe layer 30, and growing the Si thin film layer 40 on the surface of the SiGe layer 30 to form the stacked layer structure of the SiGe layer 30 and the Si thin film layer 40;
S305: simultaneously growing the first Co thin film layer 50, the second Co thin film layer 70, a third Co thin film layer 80, and a fourth Co thin film layer 90 on the stacked layer structure, on the first gate layer 22, on the second gate layer 212, and on the source-drain region of the NMOS transistor 200, respectively; and
S306: performing the annealing treatment to make the first Co thin film layer 50, the second Co thin film layer 70, the third Co thin film layer 80 and the fourth Co thin film layer 90 react with corresponding Si to generate the first CoSi₂ thin film layer 60, the second CoSi₂ thin film layer 23, a third CoSi₂ thin film layer 213 and a fourth CoSi₂ thin film layer 216, respectively.

The specific contents of each step of the method of preparing the CMOS circuit 1000 of this embodiment and the specific structures involved therein, etc., please refer to the above contents above the preparation of the PMOS transistor 100 and the structural composition of the CMOS circuit 1000, etc., which will not be repeated herein.

Further, in order to achieve electrical connection between the CMOS circuit 1000 and the peripheral circuit or device, etc., it is also necessary to carry out a contact process of the CMOS circuit 1000 to supply the signal lines of the peripheral circuit for connection, and the contact process may specifically include:
S401: depositing a first insulating layer on the surface of the CMOS circuit 1000 shown in FIG. 22, the first insulating layer may be made of silicon nitride, and the deposition process may be referred to the process of depositing each layers as mentioned above;
S402: depositing a layer of a high aspect ratio process (HARP) film on the surface of the above insulating layer, and the HARP film may be made of silicon dioxide;
S403: depositing an oxide layer on the surface of the above HARP film, this deposition step can be achieved by the High-Density Plasma (HDP)-CVD process, and the oxide layer can be made of silicon dioxide;
S404: depositing a second insulating layer on the surface of the above oxide layer, and the second insulating layer may be made of silicon nitride;
S405: forming a photoresist layer on the surface of the second insulating layer, and forming a plurality of hole positions in the photoresist layer, the above plurality of hole positions correspond to the positions of a plurality of contact holes that need to be formed on the CMOS circuit 1000, and the plurality of contact holes correspond to the gates, the sources, and the drains of the PMOS transistor 100 and the NMOS transistor 200, respectively;
S406: etching the CMOS circuit 1000 through the above plurality of hole positions from top to bottom to pass through the second insulating layer, the oxide layer, the HARP film, and the first insulating layer to form a plurality of contact holes to contact with the first CoSi₂ film layer 60, the second CoSi₂ film layer 23, the third CoSi₂ film layer 213, and the fourth CoSi₂ film layer 216;
S407: removing the photoresist layer to expose the second insulating layer on which the plurality of contact holes have been formed;
S408: depositing a metal layer on the surface of the second insulating layer, so that the metal of the metal layer is deposited along the plurality of contact holes to contact with the first CoSi₂ thin film layer 60, the second CoSi₂ thin film layer 23, the third CoSi₂ thin film layer 213 and the fourth CoSi₂ thin film layer 216, respectively. The metal to achieve the contact may be understood to be a metal signal line, and the metal layer may be made of titanium nitride;
S409: removing the metal layer on the surface of the above second insulating layer, and retaining a plurality of metal signal lines in the plurality of contact holes in contact with the first CoSi₂ thin film layer 60, the second CoSi₂ thin film layer 23, the third CoSi₂ thin film layer 213, and the fourth CoSi₂ thin film layer 216, respectively, thereby achieving the contact of the CMOS circuit 1000.

In the description of the present specification, the description with reference to the terms "first embodiment", "second embodiment", etc. is intended to mean that the specific features, structures, materials, or characteristics described in combination with the embodiments or examples are included in at least one embodiment or example of the present application. In this specification, schematic expressions of the above terms do not necessarily refer to the same embodiments or examples. Moreover, the specific features, structures, materials, or characteristics described may be combined in any one or more of the embodiments or examples in a suitable manner.

## Claims

1. A method of preparing a PMOS transistor, applicable to a fabrication of the PMOS transistor (100) with source-drain structures having line widths less than 40 nm, **characterized by** comprising:
providing a substrate (10), and forming source-drain trenches (11) on the substrate (10);
growing SiGe material within the source-drain trenches (11) to form a SiGe layer (30), and growing a Si thin film layer (40) on a surface of the SiGe layer (30) to form a stacked layer structure of the SiGe layer (30) and the Si thin film layer (40); and
growing a first Co thin film layer (50) on the stacked layer structure, and performing an annealing treatment, to make Co in the first Co thin film layer (50) react with Si in the Si thin film (40) layer to form a first CoSi₂ thin film layer (60);
wherein an overall structure formed within the source-drain trenches (11) is a source-drain, and the first CoSi₂ thin film layer (60) is an upper structure of the source-drain.

2. The method of preparing the PMOS transistor according to claim 1, further comprising:
preparing a first gate layer (22) on the substrate (10), wherein the first gate layer (22) is made of polysilicon; and
growing a second Co thin film layer (70) on the first gate layer (22), and performing the annealing treatment, to make Co in the second Co thin film layer react (70) with Si in the first gate layer (22) to form a second CoSi₂ thin film layer (23);
wherein an overall structure of the first gate layer (22) and the second CoSi₂ thin film layer (23) is a first gate (20), and the second CoSi₂ thin film layer (23) is an upper structure of the first gate (20).

3. The method of preparing the PMOS transistor according to claim 2, wherein the first Co thin film layer (50) and the second Co thin film layer (70) are grown simultaneously, and then performed by the annealing treatment, and the first CoSi₂ thin film layer (22) and the second CoSi₂ thin film layer (23) generated by reaction are the upper structure of the source-drain and the upper structure of the first gate (20), respectively.

4. The method of preparing the PMOS transistor according to claim 1, wherein in a process of growing the Si thin film layer (40) on the surface of the SiGe layer (30), a thickness of the Si thin film layer (40) is satisfied:
in a subsequent reaction with the first Co thin film layer (50) to generate the first CoSi₂ thin film layer (22), all Si contained in the Si thin film layer (40) is consumed by Co and there is no insufficient Si, and the insufficient Si means that remaining Co is still unreacted after the annealing treatment.

5. The method of preparing the PMOS transistor according to claim 4, wherein the thickness of the Si thin film layer (40) is less than 20 nm.

6. The method of preparing the PMOS transistor according to claim 1, wherein the substrate (10) is made of monocrystalline silicon (Si), monocrystalline germanium (Ge), silicon-germanium (GeSi), or silicon carbide (SiC), or silicon on insulator (SOI), germanium on insulator (GOI), or gallium arsenide.

7. The method of preparing the PMOS transistor according to claim 1, wherein the first Co thin film layer (50) is formed on the surface of the Si thin film layer (40) by physical vapour deposition.

8. The method of preparing the PMOS transistor according to claim 1, wherein the first Co thin film layer (50) is formed on the surface of the Si thin film layer (40) by magnetron sputtering.

9. The method of preparing the PMOS transistor according to claim 2, wherein before growing the second Co thin film layer (70) on the first gate layer (22), each of two sides of the first gate layer (22) is provided with a first sidewall (24), first sidewalls (24) are provided on a surface of the substrate (10) and affixed to the surfaces of two sides of the first gate layer (22).

10. A PMOS transistor, prepared by the method of any one of claims 1 to 9.

11. A CMOS circuit, **characterized by** comprising:
a substrate (10);
at least one NMOS transistor (200) formed on the substrate (10); and
at least one PMOS transistor (100) according to claim 10 formed on the substrate (10).

12. The CMOS circuit according to claim 11, wherein the NMOS transistor (200) comprises:
an active region, comprising source-drain regions for forming the source-drain of the NMOS transistor (200);
a second gate dielectric layer (211) formed on the active region; and
a second gate (210) formed on the second gate dielectric layer (211), wherein the source-drain regions are provided on two sides of the second gate (210), and the second gate (210) comprises a second gate layer (212);
wherein the second gate layer (212) is made of polysilicon.

13. A method of preparing a CMOS circuit, applied for manufacturing the CMOS circuit according to any one of claims 11 to 12, **characterized by** comprising:
providing the substrate (10), and forming at least two active regions on the substrate (10), wherein two adjacent active regions are separated by a shallow trench isolation structure (15);
forming the source-drain trenches (11) of the PMOS transistor (100) within each active region corresponding to the PMOS transistor (100);
growing SiGe material within the source-drain trenches (11) of the PMOS transistor (100) to form the SiGe layer (30), and growing the Si thin film layer (40) on the surface of the SiGe layer (30) to form the stacked layer structure of the SiGe layer (30) and the Si thin film layer (40); and
growing the first Co thin film layer (50) on the surface of the stacked layer structure, and performing an annealing treatment, to make Co in the first Co thin film layer (50) react with Si in the Si thin film layer (40) to form the first CoSi₂ thin film layer (22).

14. The method of preparing the CMOS circuit according to claim 13, wherein the NMOS transistor (200) comprises:
the active region, comprising the source-drain regions for forming the source-drain of the NMOS transistor (200);
the second gate dielectric layer (211) formed on the active region; and
the second gate (210) formed on the second gate dielectric layer (211), wherein the source-drain regions are provided on two sides of the second gate (210), and the second gate (210) comprises a second gate layer (212);
wherein the first gate layer (22) and the second gate layer (212) are both made of polysilicon.

15. The method of preparing the CMOS circuit according to claim 14, wherein the method comprises:
providing the substrate (10), and forming at least two active regions on the substrate (10), wherein two adjacent active regions are separated by the shallow trench isolation structure (15);
forming the first gate layer (22) of the PMOS transistor (100) and the second gate layer (212) of the NMOS transistor (200) simultaneously on each active region;
forming the source-drain trenches (11) of the PMOS transistor (100) within the active region corresponding to the PMOS transistor (100);
growing the SiGe material within the source-drain trenches (11) of the PMOS transistor (100) to form the SiGe layer (30), and growing the Si thin film layer (40) on the surface of the SiGe layer (30) to form the stacked layer structure of the SiGe layer (30) and the Si thin film layer (40); and
simultaneously growing the first Co thin film layer (50), the second Co thin film layer (70), a third Co thin film layer (80), and a fourth Co thin film layer (90) on the stacked layer structure, on the first gate layer (22), on the second gate layer (212), and on the source-drain regions of the NMOS transistor (200), respectively; and
performing the annealing treatment to make the first Co thin film layer (50), the second Co thin film layer (70), the third Co thin film layer (80) and the fourth Co thin film layer (90) react with corresponding Si to generate the first CoSi₂ thin film layer (22), the second CoSi₂ thin film layer (23), a third CoSi₂ thin film layer (213) and a fourth CoSi₂ thin film layer (216), respectively.
